# EUROPÄISCHE PATENTANMELDUNG

(11) **EP 1 424 749 A2**
(43) Veröffentlichungstag der Anmeldung: **02.06.2004**
(21) Anmeldenummer: 03024152.5
(22) Anmeldetag: 20.10.2003
(51) Int. Cl.: H01R 13/24

(54) **System zur elektrischen Kontaktierung mit einem Leiter, insbesondere für eine Heizungs-oder Klimaanlage für ein Kraftfahrzeug**

(30) Priorität: 29.11.2002 DE 10256104
(71) Anmelder: Behr GmbH & Co. KG, 70469 Stuttgart (DE)
(72) Erfinder: Kreuzer, Walter, 71229 Leonberg (DE); Pubrl, Harald, 70437 Stuttgart (DE); Otto, Jürgen, 75428 Illingen (DE); Schmadl, Dieter, 71672 Marbach (DE)
(74) Vertreter: Reiners, Thomas

(57) **Zusammenfassung**

Die Erfindung betrifft ein System zur elektrischen Kontaktierung eines elektrischen Bauteils (6), insbesondere für eine Heizungs- oder Klimaanlage für ein Kraftfahrzeug, mit Kontaktflächen zur Herstellung eines elektrischen Kontaktes zwischen dem elektrischen Bauteil (6) und einem elektrischen Leiter (2), der an einem Gehäuse (1) angeordnet ist, wobei zwischen elektrischem Bauteil (6) und dem Leiter (2) maximal zwei Kontaktstellen vorgesehen sind.

## Beschreibung

Die Erfindung betrifft ein System zur elektrischen Kontaktierung mit einem Leiter, insbesondere für eine Heizungs- oder Klimaanlage für ein Kraftfahrzeug.

Heutige Fahrzeugklimaanlagen werden über ein Steuergerät gesteuert bzw. geregelt, das als bauliche Einheit mit einer Bedieneinheit, die in der Mittelkonsole bzw. in der Armaturentafel angeordnet ist, ausgebildet ist. Das Bedien- und Steuergerät weist Bedienelemente, wie Schalter, Taster, Drehknöpfe usw., auf, über die Benutzereinstellungen, wie gewünschte Temperatur, gewünschte Luftverteilung etc., eingebbar sind. Die eingegebenen Signale werden in dem Steuergerät elektronisch verarbeitet und über elektrische Verbindungen, in der Regel Rundleiter, dem Klimagerät, das ein Luftführungsgehäuse mit darin angeordneten Filter, Wärmetauscher, Luftstromsteuerelementen, Aktoren und gegebenenfalls Sensoren umfasst, zugeführt. Über einen Kabelbaum sind die elektrischen Komponenten des Klimageräts, wie Sensoren und Aktoren, beispielsweise Schrittverstellmotoren für die Luftstromsteuerelemente sowie das Gebläse, elektrisch miteinander verbunden.

Die Vielzahl an Aktoren und Sensoren bringt insgesamt einen erhöhten Verkabelungsaufwand, d.h. auch einen erhöhten Aufwand zur Kontaktierung der einzelnen elektrischen Komponenten, und damit einhergehende Kosten mit sich. Üblicherweise erfolgt bei der Montage die elektrische Kontaktierung mittels Steckern, die bei der Montage in entsprechende Steckbuchsen gesteckt werden. Dies erfolgt entweder vor oder nach dem Einbau der entsprechenden Komponente bzw. der elektrischen Leitung. Ferner müssen bei einer Demontage einer Komponente die Schrauben mit einem Werkzeug gelöst und die Steckverbindung getrennt werden. Ferner sind bei der Verwendung von Steckern und entsprechenden Steckbuchsen jeweils mindestens drei Kontaktstellen vorgesehen, welche allesamt potentielle Fehlerquellen darstellen.

Aus der DE 196 05 999 A1 ist eine Kontaktierung einer flächigen Antennenleiterstruktur bekannt, welche in ein Fahrzeugeinbauteil, insbesondere eine Fahrzeugscheibe, integriert ist. Hierbei sind zur Kontaktierung erste Kontaktierungsmittel, welche auf dem Fahrzeugeinbauteil angeordnet sind, und zweite Kontaktierungsmittel, welche karosserieseitig auf mindestens einem Kontaktfuß angeordnet sind, vorgesehen. Die Kontaktierung der ersten Kontaktierungsmittel mit den korrespondierenden zweiten Kontaktierungsmitteln erfolgt durch eine Relativbewegung zwischen Fahrzeugeinbauteil und Kontaktfuß beim Einbau, wobei die Relativbewegung einerseits bei bereits eingebautem Kontaktfuß durch das Fahrzeugeinbauteil, beispielsweise durch Aufsetzen, andererseits bei bereits eingebautem Fahrzeugeinbauteil durch den Kontaktfuß, beispielsweise durch Aufstecken, ausgeführt wird. Eine derartige Kontaktierung lässt jedoch noch Wünsche offen.

Es ist Aufgabe der Erfindung, ein verbessertes System zur Kontaktierung zur Verfügung zu stellen.

Diese Aufgabe wird gelöst durch ein System mit den Merkmalen des Anspruchs 1. Vorteilhafte Ausgestaltungen sind Gegenstand der Unteransprüche.

Zur elektrischen Verbindung einer elektrischen Komponente, beispielsweise einem Gebläse oder einer Steuerungselektronik, direkt bei der Montage mit einem Gehäuse, insbesondere von einer Heizungs- oder Klimaanlage für ein Kraftfahrzeug, vorzugsweise an einem Luftführungsgehäuse, sind Kontaktflächen an der elektrischen Komponente, worauf im Folgenden auch als Bauteil Bezug genommen wird, und am entsprechenden elektrischen Leiter, beispielsweise einem Rundleiter oder einem FPC (flexible printed circuit), welcher mit dem Gehäuse verbunden ist, vorgesehen, wobei die Kontakte definiert positioniert sind, so dass gleichzeitig mit der Montage, d.h. mit der Positionierung des entsprechenden Bauteils und dessen Fixierung, der elektrische Kontakt ohne zusätzliche Handgriffe gebildet wird. Durch den Direktkontakt sind keine drei Kontaktstellen, nämlich von Leiter zu Stecker, von Stecker zu Steckbuchse und von Steckbuchse zum zweiten Leiter, erforderlich. Je nach Ausgestaltung kann ein Direktkontakt zwischen Leiter und Leiter oder aber zwischen einem Leiter und einem kontaktherstellenden Hilfsmittel, wie Schnappscheibe, Federbügel o.ä., und zwischen dem kontaktherstellenden Hilfsmittel und dem zweiten Leiter erfolgen. Dies hat insbesondere den Vorteil, dass auf Grund der Verringerung der Kontaktstellen auf maximal zwei die Zahl der potentiellen Fehlerquellen reduziert wird.

Zur Optimierung des elektrischen Kontakts ist mindestens eine der beiden Kontaktflächen der Kontaktstelle, die beim Zusammenbau geschlossen wird, elastisch ausgebildet.

Die Kontaktierung erfolgt beim Zusammenbau insbesondere von oben, schräg und/oder seitlich in Bezug auf die Gehäuseoberfläche im Kontaktierungsbereich.

Vorzugsweise ist am Gehäuse mindestens ein Positionier- und/oder Befestigungselement vorgesehen, damit eine einfache Positionierung des Bauteils am Gehäuse möglich ist und die Befestigung schnell erfolgen kann, so dass die Montage vereinfacht wird und die Herstellungskosten gesenkt werden.

Vorzugsweise wird die Kontaktfläche durch einen Vorsprung, eine Schnappscheibe, einen Federbügel, einen Buchsenkontakt oder einen Schneidklemmkontakt gebildet.

Vorzugsweise handelt es sich beim elektrischen Leiter um einen partiell flachgedrückten Rundleiter oder um einen Flachleiter, z.B. FPC oder FFC (flexible flat cable).

Bevorzugt verläuft einer der beiden Leiter im Bereich der Kontaktfläche desselben nicht gerade. Dies kann beispielsweise durch eine Anbringung eines elastischen Materials unter dem Leiter bewirkt werden, so dass der Leiter an der Kontaktstelle gebogen verläuft.

Vorzugsweise weist das Bauteil eine Platine auf, an der das kontaktbildende Element direkt angebracht ist. Alternativ kann die Elektronik auch auf einem MID Bauteil, d.h. einem räumlich spritzgegossenen Schaltungsträger mit integrierter Leiterbildstruktur, befestigt sein. Ebenfalls kann die Befestigung an einem Stanzgitter erfolgen, wobei hierbei vorzugsweise das Stanzgitter in ein Kunststoffgehäuse eingespritzt ist und die Kontaktflächen auf die Bauteile angelötet sind und freiliegen. Des weiteren ist die Verwendung einer FPC als Platine möglich, insbesondere wenn der Bauteilträger, d.h. die FPC und das Kontaktelement zum Leiter aus einem Stück gefertigt ist.

Gemäß einer bevorzugten Ausführungsform ist am Bauteil oder am Gehäuse ein elastisches Material, vorzugsweise ein Elastomer, vorgesehen, welches einen Vorsprung bildet, über welchen einer der Leiter zur Bildung der entsprechenden Kontaktfläche geführt ist.

Eine besonders schnelle und einfach Befestigung des Bauteils am Gehäuse ist mittels einer Clipsverbindung möglich, wobei die elektrische Kontaktierung kurz vor oder spätestens mit dem Schließen, d.h. dem Einrasten, der Clipsverbindung erfolgt.

Im Folgenden wird die Erfindung anhand einer Mehrzahl von Ausführungsbeispielen unter Bezugnahme auf die Zeichnung im Einzelnen erläutert. In der Zeichnung zeigen:
- Fig. 1: einen Schnitt durch ein erstes Ausführungsbeispiel;
- Fig. 2: einen Schnitt durch ein zweites Ausführungsbeispiel;
- Fig. 3: einen Schnitt durch ein drittes Ausführungsbeispiel;
- Fig. 4: einen Schnitt durch ein viertes Ausführungsbeispiel;
- Fig. 5: einen Schnitt durch ein fünftes Ausführungsbeispiel;
- Fig. 6: einen Schnitt durch ein sechstes Ausführungsbeispiel;
- Fig. 7: einen Schnitt durch ein siebtes Ausführungsbeispiel;
- Fig. 8: einen Schnitt durch ein achtes Ausführungsbeispiel;
- Fig. 9: einen Schnitt durch ein neuntes Ausführungsbeispiel;
- Fig. 10: einen Schnitt durch ein zehntes Ausführungsbeispiel;
- Fig. 11a-c: einen Schnitt durch ein elftes Ausführungsbeispiel in verschiedenen Schritten beim Zusammenbau;
- Fig. 12: eine Draufsicht auf das elfte Ausführungsbeispiel ohne Bauteil;
- Fig. 13: eine Draufsicht auf das elfte Ausführungsbeispiel mit Bauteil; und
- Fig. 14: beispielhaft verschiedene Formen möglicher Kontaktflächen.

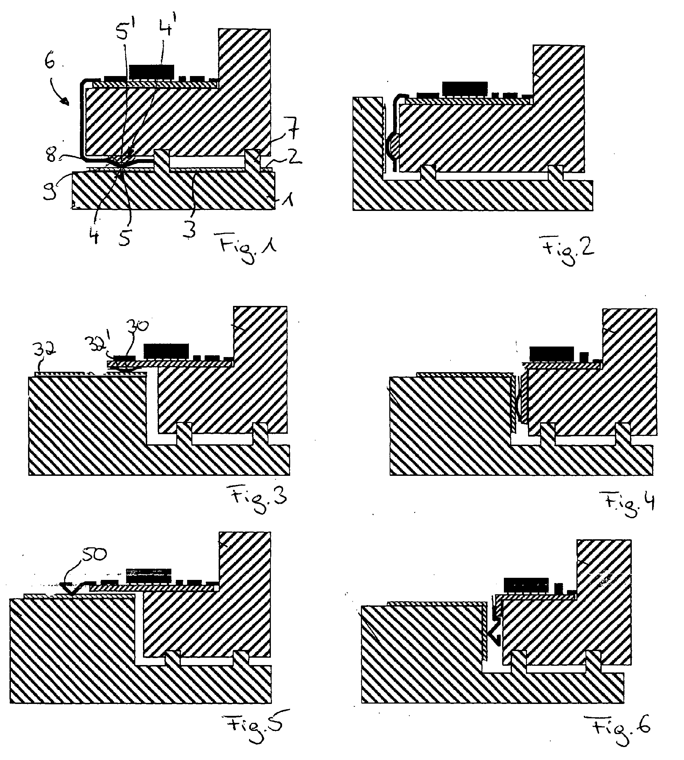

Fig. 1 zeigt ein Gehäuse 1 einer Klimaanlage für ein Kraftfahrzeug, an dem ein elektrischer Leiter 2, gemäß dem ersten Ausführungsbeispiel ein Flachleiter 3, vorliegend eine FPC, fixiert ist. Dabei ist der Leiter 2 derart ausgebildet, dass er in einem vorbestimmten Bereich 4 eine elektrische Kontaktfläche 5 aufweist, an der ein elektrischer Kontakt mit einem zweiten Leiter 2', vorliegend ebenfalls ein Flachleiter 3' in Form einer FPC, gebildet wird (Kontaktstelle). Der Flachleiter 3' ist Teil eines Bauteils, wobei es sich auch um eine Baugruppe handeln kann, welches am Gehäuse 1 angebracht ist. Gemäß dem vorliegenden Ausführungsbeispiel handelt es sich bei dem Bauteil um einen Schrittverstellmotor mit der ihm zugeordneten Elektronik. Hierbei ist an der Platine der Elektronik der Flachleiter 3' angelötet. Im Folgenden wird auf die Gesamtheit Flachleiter 3', Elektronik und restliches Bauteil als elektrische Komponente 6 Bezug genommen. Da der Flachleiter 3' Teil des Bauteils ist, ist lediglich eine Kontaktstelle vorhanden.

Ferner sind am Gehäuse 1 zwei Positionier- und Befestigungselemente 7 vorgesehen, in Fig. 1 oben am Gehäuse 1 dargestellt, mit deren Hilfe die elektrische Komponente 6 positioniert und an oder mit Hilfe von denen dieselbe fixiert wird. Gemäß dem ersten Ausführungsbeispiel ist der Bereich 4 auf der gleichen Seite wie die Befestigungselemente 7 angeordnet.

Korrespondierend zum Bereich 4 ist an der elektrischen Komponente 6 ein Bereich 4' mit einer elektrischen Kontaktfläche 5' vorgesehen. Zur Kontaktbildung ist an der elektrischen Komponente 6 ein gemäß dem vorliegenden Ausführungsbeispiel durch ein elastisches Material 8, vorliegend einem Elastomer 9 gebildeter Vorsprung 10 vorgesehen. Über diesen Vorsprung 10 ist der zweite Leiter 2' mit seinem Bereich 4' geführt, wobei die elektrische Kontaktfläche 5' durch den am weitesten vorstehenden Bereich gebildet wird. Vorliegend handelt es sich beim Bauteil, soweit es aus Kunststoff gefertigt ist, um ein 2-Komponenten-Spritzgussteil.

Bei der Montage wird die elektrische Komponente 6 mit Hilfe der beiden Befestigungselemente 7 positioniert, wodurch kurz vor Erreichen der Endposition auch die beiden elektrischen Kontaktflächen 5 und 5' miteinander in Berührung kommen. Beim weiteren Positionieren erfolgt eine Verformung des elastischen Materials 8 bis die Endposition erreicht ist. Gemäß dem vorliegenden Ausführungsbeispiel erfolgt die Kontaktierung in Zusammenbaurichtung. Bei der Verformung handelt es sich im Wesentlichen um eine elastische Verformung, so dass die elektrische Komponente 6 später problemlos ausgetauscht werden kann.

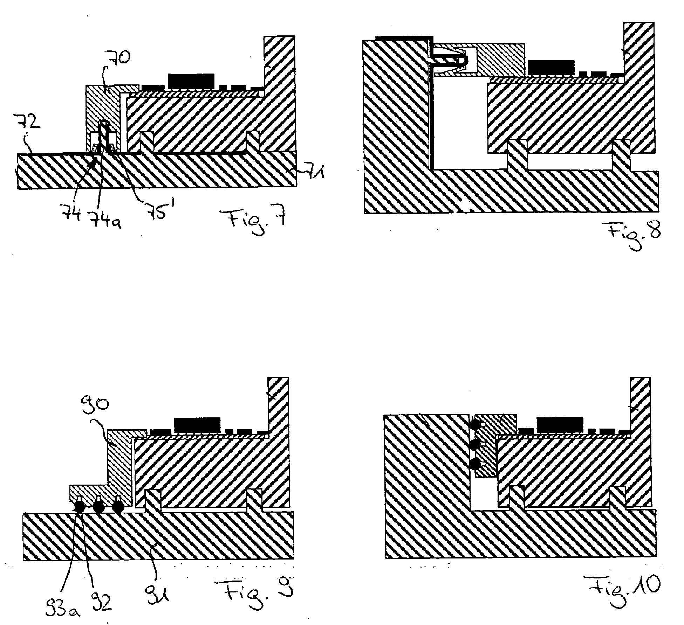

Das in Fig. 2 dargestellte, zweite Ausführungsbeispiel stimmt im Wesentlichen, d.h. in Hinblich auf die Kontaktierungsart, mit dem ersten Ausführungsbeispiel überein, jedoch erfolgt die Kontaktierung senkrecht zur Zusammenbaurichtung.

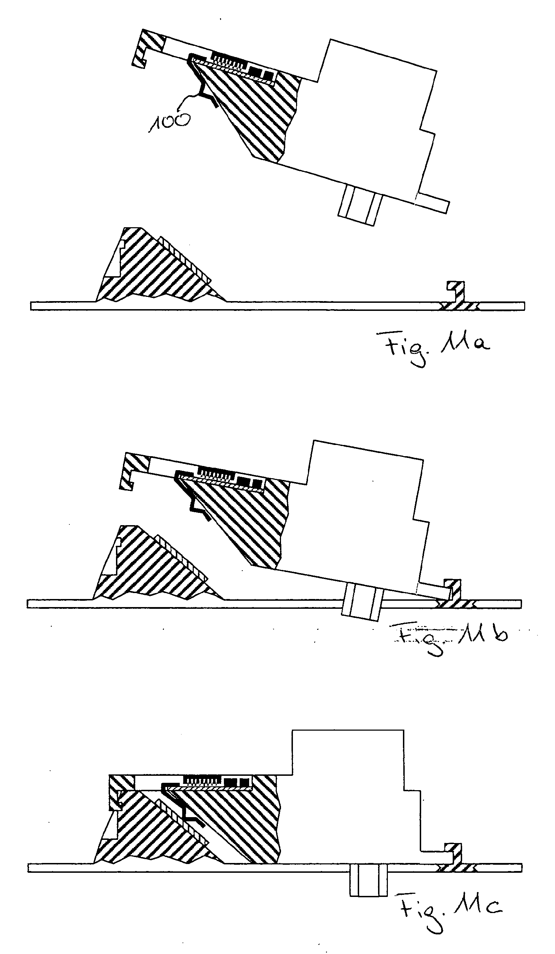

Das in Fig. 3 dargestellte, dritte Ausführungsbeispiel stimmt in Hinblick auf die Kontaktierungsrichtung im Wesentlichen mit dem ersten Ausführungsbeispiel überein, jedoch wird die Kontaktierung durch eine direkt mit der Platine von unten verbundene Schnappscheibe 30 gebildet, anstelle mit Hilfe des elastischen Materials 8. Somit bildet die Schnappscheibe 30 gleichzeitig den zweiten Leiter 32'. Ferner ist das Gehäuse 31 derart ausgebildet, dass der erste Leiter 32 knapp unterhalb der Platine positioniert ist, so dass eine direkte Kontaktierung möglich ist. Gemäß diesem Ausführungsbeispiel sind zwei Kontaktstellen vorhanden, nämlich eine zwischen erstem Leiter 32 und Schnappscheibe 30 und die zweite zwischen Schnappscheibe 30 und Platine.

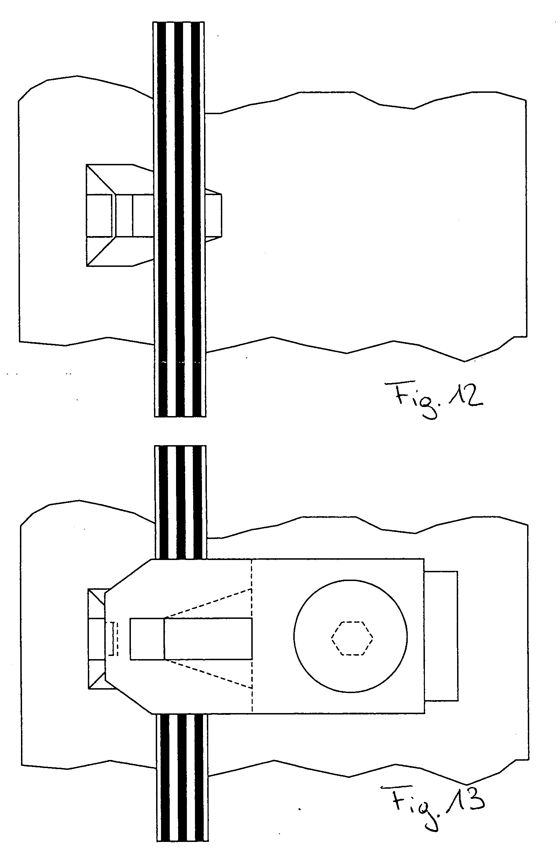

Das in Fig. 4 dargestellte, vierte Ausführungsbeispiel stimmt im Wesentlichen mit dem dritten Ausführungsbeispiel überein, jedoch erfolgt, entsprechend dem zweiten Ausführungsbeispiel die Kontaktierung senkrecht zur Zusammenbaurichtung, wozu der Platine entsprechend ausgestaltet ist, d.h. L-förmig ausgebildet ist.

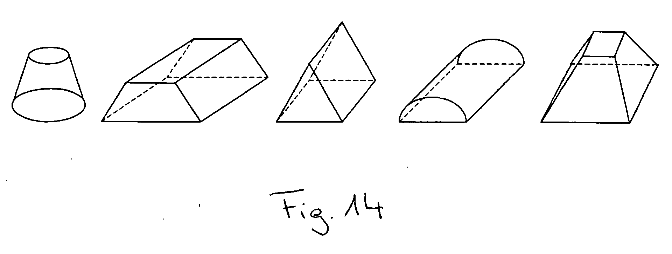

Das in Fig. 5 dargestellte fünfte Ausführungsbeispiel stimmt in Hinblick auf die Kontaktierungsrichtung im Wesentlichen mit dem dritten Ausführungsbeispiel überein, jedoch ist anstelle der von unten an der Platine angeordneten Schnappscheibe 30 ein von oben an der Platine angeordneter Federbügel 50 vorgesehen.

Das in Fig. 6 dargestellte sechste Ausführungsbeispiel stimmt in Hinblick auf die Kontaktierungsart im Wesentlichen mit dem fünften Ausführungsbeispiel überein, jedoch erfolgt, entsprechend dem vierten Ausführungsbeispiel die Kontaktierung senkrecht zur Zusammenbaurichtung, wozu der Platine entsprechend dem vierten Ausführungsbeispiel ausgestaltet ist.

Das in Fig. 7 dargestellte siebte Ausführungsbeispiel stimmt in Hinblick auf die Kontaktierungsrichtung im Wesentlichen mit dem in Fig. 5 dargestellten fünften Ausführungsbeispiel überein, jedoch ist anstelle des Federbügels 50 ein Buchsenkontakt 70 vorgesehen. Ferner ist das Gehäuse 71 entsprechend dem ersten Ausführungsbeispiel ausgebildet, wobei es im Bereich 74 einen Steg 74a aufweist, über welchen der erste Leiter 72 geführt ist, und über den der Büchsenkontakt 70 mittels zweier Kontaktflächen 75', die durch federnde Elemente gebildet werden, den elektrischen Kontakt bildet.

Das in Fig. 8 dargestellte achte Ausführungsbeispiel stimmt in Hinblick auf die Kontaktierungsart im Wesentlichen mit dem in Fig. 7 dargestellten siebten sowie in Hinblick auf die Kontaktierungsrichtung mit dem in Fig. 6 dargestellten sechsten Ausführungsbeispiel überein, jedoch erfolgt der Zusammenbau in Blickrichtung der Fig. 8, und nicht, wie in bei dem sechsten Ausführungsbeispiel von oben.

Das in Fig. 9 dargestellte neunte Ausführungsbeispiel stimmt in Hinblick auf die Kontaktierungsrichtung im Wesentlichen mit dem in Fig. 7 dargestellten achten Ausführungsbeispiel überein, jedoch ist als elektrischer Leiter 92 anstelle des Flachleiters 3 ein Rundleiter 93a am Gehäuse 91 fixiert, welcher mittels eines Schneidklemmenkontakts 90 kontaktiert wird. Hierbei schabt- oder drückt sich der Schneidklemmenkontakt 90 in den Rundleiter 93a ein.

Das in Fig. 10 dargestellte zehnte Ausführungsbeispiel stimmt in Hinblick auf die Kontaktierungsart im Wesentlichen mit dem in Fig. 9 dargestellten neunten sowie in Hinblick auf die Kontaktierungsrichtung im Wesentlichen dem in Fig. 8 dargestellten achten Ausführungsbeispiel überein.

In der Fig. 11c ist ein elftes Ausführungsbeispiel dargestellt, welches im Wesentlichen dem fünften Ausführungsbeispiel entspricht. Hierbei erfolgt die Kontaktierung mit Hilfe eines Federbügels 100 an einer Schräge. Für den Zusammenbau, der in den Fig. 11a bis 11c dargestellt ist, wird das Bauteil mit einem Vorsprung in eine Aufnahme eingesetzt (Fig. 11 b) und um eine durch diese Aufnahme verlaufende Achse verschwenkt bis eine Clipsverbindung einschnappt (Fig. 11c) und eine sichere Verbindung zwischen Bauteil und Gehäuse gewährleistet. Die elektrische Kontaktierung erfolgt kurz vor Beendigung der Schwenkbewegung, wobei der Federbügel 100 leicht elastisch verformt wird.

In Fig. 14 sind verschiedenen bevorzugte Formen für die Kontaktflächen dargestellt, jedoch kann beispielsweise auch der Elastomer gemäß dem ersten und zweiten Ausführungsbeispiel eine entsprechende Form aufweisen.

### Bezugszeichenliste

1, 71, 91 Gehäuse
2, 2', 32, 32', 72, 92 elektrischer Leiter
3, 3' Flachleiter
4, 4', 74 Bereich
5, 5', 75' elektrische Kontaktfläche
6 elektrische Komponente
7 Befestigungselement
8 elastisches Material
9 Elastomer
10 Vorsprung
30 Schnappscheibe
50, 100 Federbügel
70 Buchsenkontakt
74a Steg
90 Schneidklemmenkontakt
93a Rundleiter

## Patentansprüche

1. System zur elektrischen Kontaktierung eines elektrischen Bauteils (6), insbesondere für eine Heizungs- oder Klimaanlage für ein Kraftfahrzeug, mit Kontaktflächen zur Herstellung eines elektrischen Kontaktes zwischen dem elektrischen Bauteil (6) und einem elektrischen Leiter (2; 32; 72; 92), der an einem Gehäuse (1; 71; 91) angeordnet ist, wobei zwischen elektrischem Bauteil (6) und dem Leiter (2; 32; 72; 92) maximal zwei Kontaktstellen vorgesehen sind.

2. System nach Anspruch 1, **dadurch gekennzeichnet, dass** mindestens eine der beiden Kontaktflächen wenigstens einer Kontaktstelle elastisch ausgebildet ist.

3. System nach Anspruch 1 oder 2, **dadurch gekennzeichnet, dass** direkt am elektrischen Bauteil (6) oder über eine einzige elektrische Kontaktstelle verbunden mit dem elektrischen Bauteil (6) ein Bereich (4') mit einer elektrischen Kontaktfläche (5') vorgesehen ist, der direkt den am Gehäuse (1; 71; 91) angeordneten Leiter (2; 32; 72; 92) an einer Kontaktfläche (5) kontaktiert.

4. System nach einem der vorstehenden Ansprüche, **dadurch gekennzeichnet, dass** die Kontaktfläche des am Gehäuse (1; 71; 91) angeordneten Leiters (2; 32; 72; 92) oben, schräg und/oder seitlich bezogen auf die Gehäuseoberfläche im Kontaktierungsbereich vorgesehen ist.

5. System nach einem der vorstehenden Ansprüche, **dadurch gekennzeichnet, dass** am Gehäuse (1; 71; 91) mindestens ein Positionierund/oder Befestigungselement (7) vorgesehen ist.

6. System nach einem der vorstehenden Ansprüche, **dadurch gekennzeichnet, dass** die Kontaktfläche (5'; 75') durch einen Vorsprung (10), eine Schnappscheibe (30), einen Federbügel (50; 100), einen Buchsenkontakt (70) oder einen Schneidklemmkontakt (90) gebildet ist.

7. System nach einem der vorstehenden Ansprüche, **dadurch gekennzeichnet, dass** die Kontaktfläche (5) durch einen Flachleiter (3) oder einen Rundleiter (93a) gebildet ist.

8. System nach Anspruch 7, **dadurch gekennzeichnet, dass** der Leiter im Bereich der Kontaktfläche (5) nicht gerade verläuft.

9. System nach einem der vorstehenden Ansprüche, **dadurch gekennzeichnet, dass** das Bauteil (6) eine Platine, ein MID Bauteil mit hieran angebrachter Elektronik, ein Stanzgitter oder eine FPC aufweist.

10. System nach Anspruch 9, **dadurch gekennzeichnet, dass** an der Platine ein Leiter (2') kontaktiert ist, der mit dem Leiter (2) den elektrischen Kontakt direkt bildet.

11. System nach Anspruch 10, **dadurch gekennzeichnet, dass** ein elastisches Material (8) vorgesehen ist, welches einen Vorsprung (10) bildet, über welchen einer der Leiter (2; 2') zur Bildung der entsprechenden Kontaktfläche (5; 5') geführt ist.

12. System nach Anspruch 11, **dadurch gekennzeichnet, dass** das elastische Material (8) ein Elastomer (9) ist.

13. System nach einem der vorstehenden Ansprüche, **dadurch gekennzeichnet, dass** die kontaktbildenden Elemente (10; 30; 50; 70; 90) direkt an der Platine kontaktiert sind.

14. System nach Anspruch 13, **dadurch gekennzeichnet, dass** die kontaktbildenden Elemente (30; 50; 70; 90; 100) direkt an der Platine befestigt sind.

15. System nach einem der vorstehenden Ansprüche, **dadurch gekennzeichnet, dass** das Bauteil ( 6) auswechselbar ist.

16. System nach einem der vorstehenden Ansprüchen, **dadurch gekennzeichnet, dass** das Bauteil mittels einer Clipsverbindung am Gehäuse befestigt ist.

17. System nach Anspruch 16, **dadurch gekennzeichnet, dass** die Clipsverbindung ein Elastomer ist.
